# EUROPEAN PATENT APPLICATION

(11) **EP 4 633 348 A1**
(43) Date of publication of application: **15.10.2025**
(21) Application number: 23900445.0
(22) Date of filing: 21.11.2023
(51) Int. Cl.: H10N 10/817, C22C 23/00, C22F 1/06, H10N 10/01, H10N 10/852

(54) **THERMOELECTRIC CONVERSION ELEMENT, THERMOELECTRIC CONVERSION MODULE, THERMOELECTRIC CONVERSION SYSTEM, ELECTRIC POWER GENERATION METHOD, AND METHOD FOR PRODUCING THERMOELECTRIC CONVERSION ELEMENT**

(30) Priority: 08.12.2022 JP 2022196648
(71) Applicant: Panasonic Intellectual Property Management Co., Ltd., Kadoma-shi, Osaka 571-0057 (JP)
(72) Inventor: KAWABE, Takeshi, Kadoma-shi, Osaka 571-0057 (JP); TAMAKI, Hiromasa, Kadoma-shi, Osaka 571-0057 (JP)
(74) Representative: Grünecker Patent- und Rechtsanwälte PartG mbB
(86) International application number: PCT/JP2023/041706
(87) International publication number: WO 2024/122326

(57) **Abstract**

The present disclosure provides a thermoelectric conversion element that is advantageous in terms of decreasing an electrical resistance of thermoelectric conversion elements. According to the present disclosure, a thermoelectric conversion element (10a) includes a first metal layer (12a), a second metal layer (12b), and a thermoelectric conversion layer (11). The thermoelectric conversion layer (11) is disposed between the first metal layer (12a) and the second metal layer (12b) in a thickness direction of the first metal layer (12a). The thermoelectric conversion layer (11) includes a thermoelectric conversion material containing Mg. The first metal layer (12a) includes ceramic particles (12p). The ceramic particles (12p) are disposed within an interior of the first metal layer (12a).

## Description

### BACKGROUND

### 1. Technical Field

The present disclosure relates to a thermoelectric conversion element, a thermoelectric conversion module, a thermoelectric conversion system, a method for generating electrical power, and a method for manufacturing a thermoelectric conversion element.

### 2. Description of the Related Art

In the related art, thermoelectric conversion elements are known. For example, an N-type thermoelectric conversion element including an N-type thermoelectric conversion material can be electrically connected to a P-type thermoelectric conversion element including a P-type thermoelectric conversion material to provide a thermoelectric conversion module. A known approach for facilitating the electrical coupling between the thermoelectric conversion elements is to form a layer of a metal material on an end surface portion of the thermoelectric conversion material. Thermoelectric conversion elements including a thermoelectric conversion material having such an end surface portion are easy to handle and to assemble.

Patent Literature 1, for example, describes a magnesium-antimony-based thermoelectric element. This thermoelectric element includes a magnesium-antimony-based thermoelectric material substrate layer positioned in the center of the thermoelectric element, transition layers attached to two surfaces of the substrate layer, and electrode layers attached to surfaces of the two transition layers. The transition layers are made of a magnesium-copper alloy and/or a magnesium-aluminum alloy. The electrode layers are made of copper.

Patent Literature 2 describes a magnesium-antimony-based thermoelectric element. This thermoelectric element includes a magnesium-antimony-based thermoelectric material substrate layer positioned in the center of the thermoelectric element, transition layers attached to two surfaces of the substrate layer, and electrode layers attached to surfaces of the two transition layers. The transition layers are made of a titanium-copper alloy or a magnesium-copper alloy. The electrode layers are copper and/or nickel.

Patent Literature 3 describes a thermoelectric conversion element including electrodes, intermediate layers, and a thermoelectric conversion layer. The intermediate layers are each provided between the thermoelectric conversion layer and the electrode. The intermediate layers are in contact with the thermoelectric conversion layer. The thermoelectric conversion layer contains Mg, at least one element selected from the group consisting of Sb and Bi, and at least one element selected from the group consisting of Se and Te. The electrodes are composed of a CuZn alloy. The composition of the intermediate layers are different from the composition of the electrodes and the composition of the thermoelectric conversion layer. The intermediate layers contain Cu, Zn, and Mg.

Patent Literature 4 describes a polycrystalline-magnesium-silicide-based thermoelectric conversion material in which silicon carbide is present in the grain interior.

Patent Literature 5 describes a thermoelectric conversion material made of a sintered body of an alloy containing at least two or more elements selected from the group consisting of Bi, Te, Se, and Sb. This thermoelectric conversion material includes predetermined non-oxide ceramic particles in the sintered body. In the thermoelectric conversion material, some or all of the non-oxide ceramic particles are present in the grain interior of the alloy phase.

### CITATION LIST

### Patent Literature

PTL 1: Chinese Patent No. 111613715
PTL 2: Chinese Patent No. 110635020
PTL 3: International Publication No. 2020/003554
PTL 4: Japanese Unexamined Patent Application Publication No. 2020-167317
PTL 5: Japanese Unexamined Patent Application Publication No. 9-74229

### SUMMARY

The present disclosure provides a thermoelectric conversion element that is advantageous in terms of decreasing an electrical resistance of thermoelectric conversion elements that include a thermoelectric conversion material containing Mg.

### Solution to Problem

According to the present disclosure, a thermoelectric conversion element comprises a first metal layer; a second metal layer; and a thermoelectric conversion layer that is disposed between the first metal layer and the second metal layer in a thickness direction of the first metal layer and comprises a thermoelectric conversion material comprising Mg, wherein the first metal layer comprises ceramic particles, and the ceramic particles are disposed within an interior of the first metal layer.

### Advantageous Effects of Invention

The present disclosure can provide a thermoelectric conversion element that includes a thermoelectric conversion material containing Mg and that is advantageous in terms of decreasing an electrical resistance of the thermoelectric conversion element.

### BRIEF DESCRIPTION OF DRAWINGS

[Fig. 1A] Fig. 1A is a schematic cross-sectional view illustrating an exemplary thermoelectric conversion element of a first embodiment.
[Fig. 1B] Fig. 1B is a schematic cross-sectional view illustrating another exemplary thermoelectric conversion element.
[Fig. 1C] Fig. 1C is a schematic cross-sectional view illustrating yet another exemplary thermoelectric conversion element.
[Fig. 1D] Fig. 1D is a schematic cross-sectional view illustrating still another exemplary thermoelectric conversion element.
[Fig. 1E] Fig. 1E is a schematic cross-sectional view illustrating yet another exemplary thermoelectric conversion element.
[Fig. 1F] Fig. 1F is a schematic cross-sectional view illustrating still another exemplary thermoelectric conversion element.
[Fig. 2] Fig. 2 is a schematic diagram illustrating a La₂O₃-type crystal structure.
[Fig. 3] Fig. 3 is a flowchart illustrating a method for manufacturing the thermoelectric conversion element of the first embodiment.
[Fig. 4] Fig. 4 is a cross-sectional view illustrating an exemplary thermoelectric conversion module of a second embodiment.
[Fig. 5] Fig. 5 is a cross-sectional view illustrating another exemplary thermoelectric conversion module of the second embodiment.
[Fig. 6] Fig. 6 is a cross-sectional view illustrating yet another exemplary thermoelectric conversion module of the second embodiment.
[Fig. 7] Fig. 7 is a side view illustrating a thermoelectric conversion system of a third embodiment.
[Fig. 8] Fig. 8 is a photograph showing a thermoelectric conversion element of the working example 1.
[Fig. 9] Fig. 9 is a schematic diagram illustrating a manner of measuring an electrical resistance of a thermoelectric conversion element.
[Fig. 10] Fig. 10 is a graph showing exemplary results of measuring the electrical resistance of the thermoelectric conversion element of the working example 1.
[Fig. 11A] Fig. 11A is a micrograph of a cross section of the thermoelectric conversion element of the working example 1, the micrograph having been obtained by scanning transmission electron microscope-energy dispersive X-ray spectroscopy (SEM-EDX).
[Fig. 11B] Fig. 11B is a micrograph of a cross section of the thermoelectric conversion element of the working example 1, the micrograph having been obtained by SEM-EDX.
[Fig. 12] Fig. 12 is a micrograph of a cross section of a thermoelectric conversion element of Comparative the working example 1, the micrograph having been obtained by SEM-EDX.
[Fig. 13] Fig. 13 is a photograph showing peeling of a plated film of the comparative example 3.

### DESCRIPTION OF EMBODIMENTS

### (Underlying Knowledge Forming Basis of the Present Disclosure)

Possible methods for forming a metal layer include electrolytic plating and electroless plating. If physical adhesion at an interface between the plated material and the plating material is low, an interface resistivity at the interface may increase. The same applies to techniques for forming a metal layer other than plating, such as thermal spraying.

The present inventors conducted studies and found that in an instance where, for example, a metal layer containing a metal, such as Cu, is formed on a layer including a thermoelectric conversion material containing Mg, by using a plating method or the like, the interface resistivity between the metal layer and the layer including the thermoelectric conversion material is likely to increase. In further studies conducted by the present inventors, the present inventors found that a cut surface or a polished surface of the layer including a thermoelectric conversion material included ceramic particles embedded therein, which was presumed to be a cause of the increase in the interface resistivity. The present inventors believe that the ceramic particles were derived from an abrasive that was used for the cutting or polishing.

Patent Literature 1, 2, and 3 describe some materials that can serve as the metal layer that is to be in contact with the layer including a thermoelectric conversion material containing Mg. Patent Literature 1, 2, and 3, however, do not provide any discussion of the influence of an abrasive.

From Patent Literature 4, it is appreciated that the polycrystalline-magnesium-silicide-based thermoelectric conversion material, in which silicon carbide is present in the grain interior, has high mechanical strength. Patent Literature 4, however, does not provide any discussion of the influence that may be exerted on the interface resistivity by the ceramic particles present on the cut surface or the polished surface of the layer including a thermoelectric conversion material.

From Patent Literature 5, it is appreciated that the thermoelectric conversion material has high mechanical strength as a result of the inclusion of the predetermined non-oxide ceramic particles in the sintered body. Patent Literature 5, however, does not provide any discussion of the influence that may be exerted on the interface resistivity by the ceramic particles present on the cut surface or the polished surface of the layer including a thermoelectric conversion material.

Accordingly, the present inventors made numerous trial-and-error attempts to solve the problems that may occur in the instance where a metal layer is formed in contact with the layer including a thermoelectric conversion material containing Mg. As a result, the present inventors newly discovered that in an instance where a metal layer is formed in contact with the layer including a thermoelectric conversion material containing Mg, and thereafter, a specific treatment is performed, a relationship between the ceramic particles, which are derived from an abrasive or the like, and the metal layer is adjusted to be placed in a predetermined state. The present inventors also newly discovered that the interface resistivity between the metal layer and the layer including the thermoelectric conversion material can be consequently decreased. Based on these new findings, the present inventors completed the thermoelectric conversion element of the present disclosure.

### (Embodiments of the Present Disclosure)

Embodiments of the present disclosure will be described below with reference to the drawings.

### (First Embodiment)

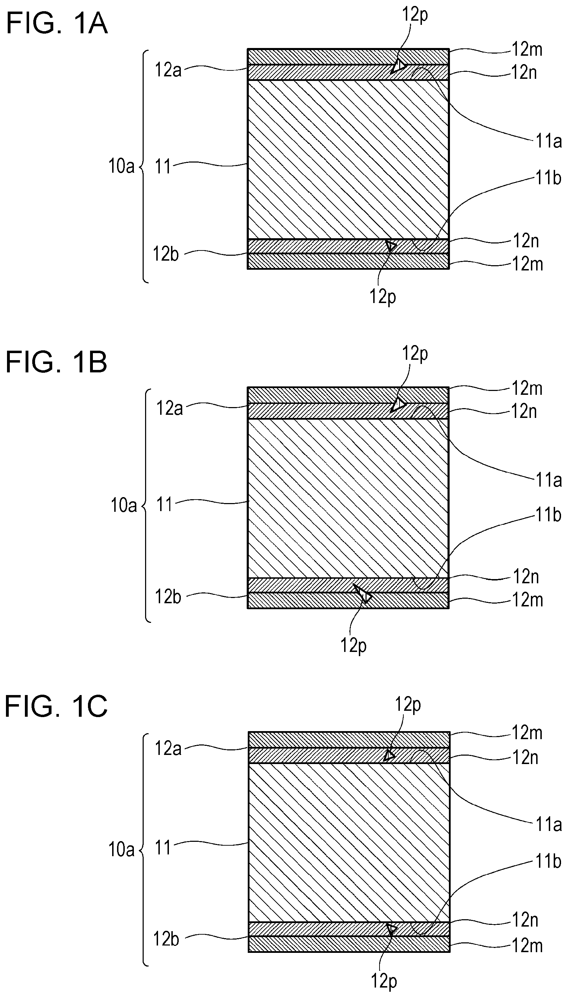

Fig. 1A is a schematic cross-sectional view illustrating an exemplary thermoelectric conversion element of a first embodiment. As illustrated in Fig. 1A, a thermoelectric conversion element 10a includes a first metal layer 12a, a second metal layer 12b, and a thermoelectric conversion layer 11. The thermoelectric conversion layer 11 is disposed between the first metal layer 12a and the second metal layer 12b in a thickness direction of the first metal layer 12a. The thermoelectric conversion layer 11 includes a thermoelectric conversion material containing Mg. The first metal layer 12a includes ceramic particles 12p. The ceramic particles 12p are disposed within an interior of the first metal layer 12a. In other words, the ceramic particles 12p are present at positions spaced from a boundary between the first metal layer 12a and an outside of the first metal layer 12a. For example, the ceramic particles 12p are not in contact with the thermoelectric conversion layer 11 and are present at positions spaced from the thermoelectric conversion layer 11.

Since the ceramic particles 12p are disposed within the interior of the first metal layer 12a, an interface resistivity at an interface between the first metal layer 12a and the outside of the first metal layer 12a is likely to be decreased. Consequently, the thermoelectric conversion element 10a is likely to have a low electrical resistance.

The thermoelectric conversion layer 11 has, for example, a first end 11a and a second end 11b in the thickness direction of the first metal layer 12a. The first metal layer 12a is, for example, in contact with the first end 11a. In this instance, since the ceramic particles 12p are present within the interior of the first metal layer 12a, interface resistance at the interface between the first metal layer 12a and the thermoelectric conversion layer 11 is likely to be decreased. The second metal layer 12b is, for example, in contact with the second end 11b.

The second metal layer 12b has, for example, a configuration similar to that of the first metal layer 12a and may include ceramic particles 12p within an interior of the second metal layer 12b. The descriptions of the first metal layer 12a apply to the second metal layer 12b as long as there is no technical inconsistency. As illustrated in Fig. 1A, the ceramic particles 12p may be present, for example, within the interiors of both the first metal layer 12a and the second metal layer 12b.

In the thermoelectric conversion element 10a, the ceramic particles 12p may be present only in the first metal layer 12a or in both the first metal layer 12a and the second metal layer 12b.

The ceramic particles 12p are not limited to any particular ceramic particles. For example, the ceramic particles 12p are non-metallic inorganic particles. The ceramic particles 12p may be particles containing a material made of a non-metallic element, such as silicon or diamond, or may be particles containing an inorganic compound, such as a metal oxide, a metal carbide, or a metal nitride. The ceramic particles 12p may or does not have to have been heat-treated. The ceramic particles 12p may be derived, for example, from an abrasive or a tool used for the polishing, cutting, or the like of the thermoelectric conversion material. The ceramic particles 12p are, for example, ceramic particles. The ceramic particles 12p may contain alumina. The ceramic particles 12p may contain at least one selected from the group consisting of SiC and SiO₂.

The presence of the ceramic particles 12p can be confirmed, for example, by observing a cross section of the first metal layer 12a in the thickness direction thereof, by scanning electron microscopy-energy dispersive X-ray spectroscopy (SEM-EDX). The SEM-EDX is performed on a clean surface of the thermoelectric conversion element 10a. The clean surface is formed by performing sputtering with Ar ions, such that the clean surface contains the interface between the thermoelectric conversion layer 11 and the first metal layer 12a or the second metal layer 12b and is perpendicular to the interface.

A size of the ceramic particles 12p is not limited to any particular value. In a cross section of the first metal layer 12a in the thickness direction thereof as observed by scanning electron microscopy-energy dispersive X-ray spectroscopy (SEM-EDX), the ceramic particles 12p satisfy, for example, a condition expressed as 0.5 µm ≤ d. In this condition, d is the maximum dimension of the ceramic particles 12p. The maximum dimension d of the ceramic particles 12p can be determined, for example, by using an elemental mapping image of the cross section of the first metal layer 12a in the thickness direction thereof.

In the cross section, the maximum dimension d of the ceramic particles 12p satisfies, for example, a second condition expressed as d ≤ 10 µm.

The metal that is included in the first metal layer 12a and the second metal layer 12b is not limited to any particular metal. The first metal layer 12a and the second metal layer 12b may contain Cu or Ni.

As illustrated in Fig. 1A, the first metal layer 12a further includes an electrode layer 12m and an intermediate layer 12n. The electrode layer 12m contains Cu. The intermediate layer 12n is disposed between the electrode layer 12m and the thermoelectric conversion layer 11 in the thickness direction of the first metal layer 12a. The intermediate layer 12n contains Mg and Cu.

In the first metal layer 12a, the ceramic particles 12p are disposed in at least one selected from the group consisting of (a), (b), and (c), which will be listed below. In this instance, the interface resistivity at the interface between the first metal layer 12a and the outside of the first metal layer 12a is likely to be further decreased, which makes it likely that the thermoelectric conversion element 10a has a lower electrical resistance.
(a) An interior of the electrode layer 12m
(b) An interior of the intermediate layer 12n
(c) A boundary region between the electrode layer 12m and the intermediate layer 12n

The intermediate layer 12n is formed, for example, as a diffusion layer. The intermediate layer 12n is formed, for example, by diffusing Mg derived from a raw material of the thermoelectric conversion layer 11, in the first metal layer 12a or the second metal layer 12b.

As illustrated in Fig. 1A, the electrode layer 12m is, for example, in contact with the intermediate layer 12n. The electrode layer 12m may be spaced from the intermediate layer 12n in the thickness direction of the first metal layer 12a. Regarding (c), which has been mentioned above, in the instance where the electrode layer 12m is in contact with the intermediate layer 12n, the boundary region includes the boundary therebetween. In the instance where the electrode layer 12m is spaced from the intermediate layer 12n in the thickness direction of the first metal layer 12a, the boundary region includes a region between the layers.

As illustrated in Fig. 1A, the second metal layer 12b further includes an electrode layer 12m and an intermediate layer 12n as with the first metal layer 12a. In the second metal layer 12b, the intermediate layer 12n is disposed between the electrode layer 12m and the thermoelectric conversion layer 11 in a thickness direction of the second metal layer 12b. In this instance, the ceramic particles 12p may be disposed in at least one selected from the group consisting of (a), (b), and (c), which have been listed above, in the second metal layer 12b.

In the instance where the ceramic particles 12p are included in both the first metal layer 12a and the second metal layer 12b, the manner in which the ceramic particles 12p are disposed may be the same as or different from each other between the first metal layer 12a and the second metal layer 12b.

An example illustrated in Fig. 1A is as follows. In the first metal layer 12a, the ceramic particles 12p are present in a region extending from the interior of the electrode layer 12m to the interior of the intermediate layer 12n with the boundary being present between the electrode layer 12m and the intermediate layer 12n. In the second metal layer 12b, the ceramic particles 12p are present only within the interior of the intermediate layer 12n.

Fig. 1B is a schematic cross-sectional view illustrating another exemplary thermoelectric conversion element 10a. As illustrated in Fig. 1B, in each of the first metal layer 12a and the second metal layer 12b, the ceramic particles 12p may be present in a region extending from the interior of the electrode layer 12m to the interior of the intermediate layer 12n with the boundary being present between the electrode layer 12m and the intermediate layer 12n.

Fig. 1C is a schematic cross-sectional view illustrating yet another exemplary thermoelectric conversion element. As illustrated in Fig. 1C, in each of the first metal layer 12a and the second metal layer 12b, the ceramic particles 12p may be present only within the interior of the intermediate layer 12n.

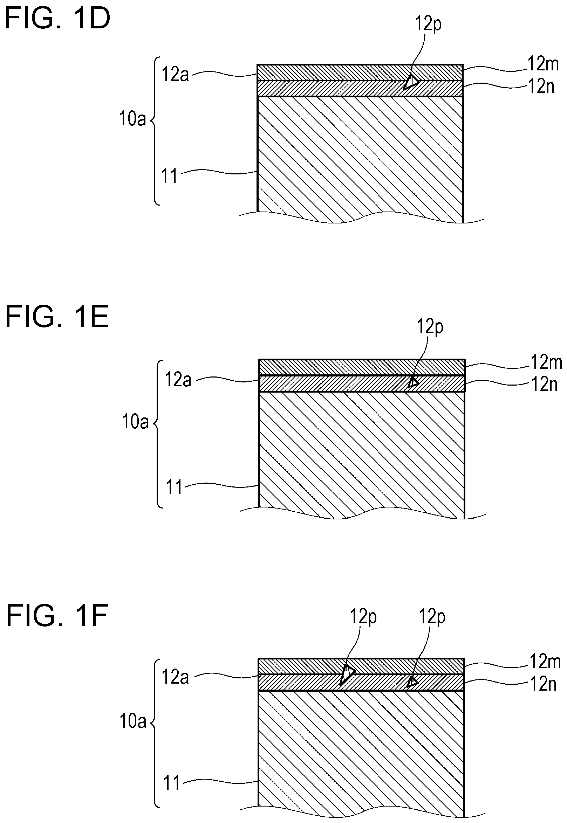

Figs. 1D, 1E, and 1F are each a schematic cross-sectional view illustrating still another exemplary thermoelectric conversion element. In the thermoelectric conversion element 10a, the ceramic particles 12p may be present only in the first metal layer 12a, as stated above. In this instance, as illustrated in Fig. 1D, the ceramic particles 12p may be present, for example, in a region extending from the interior of the electrode layer 12m to the interior of the intermediate layer 12n with the boundary being present between the electrode layer 12m and the intermediate layer 12n. As illustrated in Fig. 1E, the ceramic particles 12p may be present only within the interior of the intermediate layer 12n. As illustrated in Fig. 1F, some of the ceramic particles 12p may be present in a region extending from the interior of the electrode layer 12m to the interior of the intermediate layer 12n with the boundary being present between the electrode layer 12m and the intermediate layer 12n, and other ceramic particles 12p may be present within the interior of the intermediate layer 12n.

As stated above, the ceramic particles 12p may be disposed in the intermediate layer 12n. In this instance, the first metal layer 12a or the second metal layer 12b may satisfy a condition expressed as 0.1 ≤ d/A ≤ 10. In this instance, the interface resistivity at the interface between the first metal layer 12a and the outside of the first metal layer 12a is likely to be further decreased, which makes it likely that the thermoelectric conversion element 10a has a lower electrical resistance. d is the maximum dimension of the ceramic particles 12p in a cross section of the first metal layer 12a or the second metal layer 12b in the thickness direction thereof as observed by SEM-EDX. A is a thickness of the intermediate layer 12n.

A shape of the thermoelectric conversion element 10a is not limited to any particular shape. For example, the thermoelectric conversion element 10a is generally rectangular-parallelepiped-shaped. The shape of the thermoelectric conversion element 10a may be any shape in which the thermoelectric conversion layer 11 containing a thermoelectric conversion material can be formed. The shape may be, for example, a rectangular parallelepiped shape, a cubic shape, a generally cubic shape, any other prismatic shape, a generally prismatic shape, a cylindrical shape, or a tubular shape.

The thickness of the thermoelectric conversion layer 11 is not limited to any particular value. The thickness is, for example, greater than or equal to 0.1 mm and less than or equal to 5.0 mm. The thickness of the thermoelectric conversion layer 11 may be adjusted to be within a predetermined range by, for example, dry-polishing a component including the thermoelectric conversion material. The thickness of the thermoelectric conversion layer 11 may be adjusted to be within a predetermined range by cutting a component including the thermoelectric conversion material into multiple pieces with a wire saw or a blade saw. The thickness of the thermoelectric conversion layer 11 may be adjusted to be within a predetermined range by performing dry polishing in combination with the use of a wire saw or a blade saw.

The thermoelectric conversion material that is included in the thermoelectric conversion layer 11 is not limited to any particular material as long as the thermoelectric conversion material contains Mg. For example, the thermoelectric conversion material further contains at least one selected from the group consisting of Sb and Bi. In this instance, the thermoelectric conversion element 10a is likely to exhibit desired thermoelectric properties. The thermoelectric conversion material is, for example, an N-type thermoelectric conversion material. The thermoelectric conversion material may further contain Si and may be a magnesium silicide-based thermoelectric conversion material.

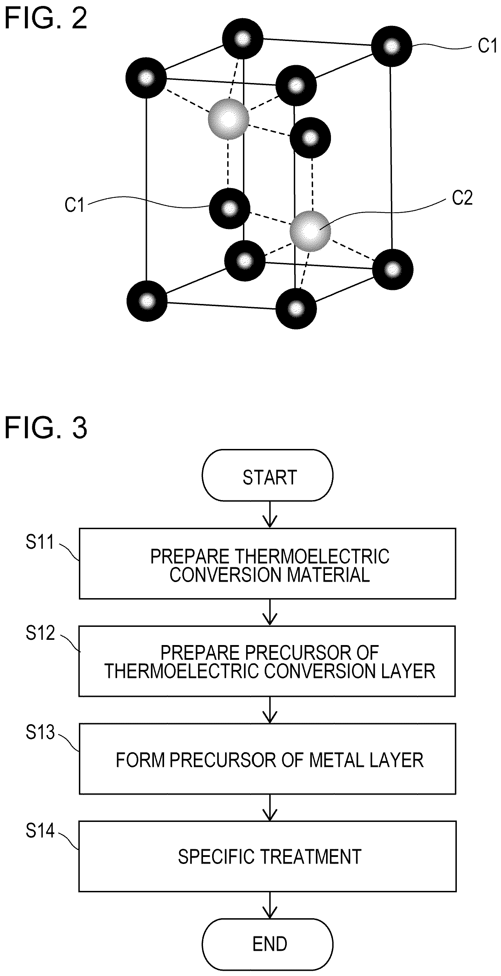

The thermoelectric conversion material that is included in the thermoelectric conversion layer 11 has, for example, a La₂O₃-type crystal structure. In this instance, the thermoelectric conversion element 10a is more likely to exhibit desired thermoelectric properties. Whether the thermoelectric conversion material has a La₂O₃-type crystal structure can be determined, for example, based on the results of an X-ray diffraction measurement of a sample of the thermoelectric conversion material. Fig. 2 is a schematic diagram illustrating a La₂O₃-type crystal structure. In the instance where the thermoelectric conversion material has a La₂O₃-type crystal structure, an example is as follows: referring to Fig. 2, Mg is positioned at a C1 site, and at least one selected from the group consisting of Sb and Bi is positioned at a C2 site. As illustrated in Fig. 2, a bond, indicated by the dashed line, is formed between the C1 site and the C2 site.

The thermoelectric conversion material, for example, further contains Te. In this instance, the thermoelectric conversion element 10a is more likely to exhibit desired thermoelectric properties.

The thermoelectric conversion material has, for example, a composition represented by Mg₃₊ₘRₐT_{b}Sb_{2-e-c}Bi_{c}Zₑ. In this composition, the element R is at least one element selected from the group consisting of Ca, Sr, Ba, and Yb. The element T is at least one element selected from the group consisting of Mn and Zn. The element Z is at least one element selected from the group consisting of Te, Se, Sc, Y, and La. The value of m satisfies -0.39 ≤ m ≤ 0.42. The value of a satisfies 0 ≤ a ≤ 0.12. The value of b satisfies 0 ≤ b ≤ 0.48. The value of c satisfies 0 ≤ c ≤ 1.6. The value of e satisfies 0.001 ≤ e ≤ 0.06. In this instance, the thermoelectric conversion element 10a is more likely to exhibit desired thermoelectric properties.

In the first metal layer 12a and the second metal layer 12b, the thickness of the electrode layer 12m is not limited to any particular value. The thickness of the electrode layer 12m is, for example, greater than or equal to 0.5 µm and less than or equal to 100 µm and is desirably greater than or equal to 0.5 µm and less than or equal to 10 µm. In the first metal layer 12a and the second metal layer 12b, the thickness of the intermediate layer 12n is not limited to any particular value. The thickness of the intermediate layer 12n is, for example, greater than or equal to 0.01 µm and less than or equal to 100 µm and is desirably greater than or equal to 0.01 µm and less than or equal to 50 µm. In the first metal layer 12a and the second metal layer 12b, the thickness of the electrode layer 12m and the thickness of the intermediate layer 12n may be the same as or different from each other.

The electrode layer 12m contains, for example, Cu or an alloy containing Cu. The intermediate layer 12n is, for example, a diffusion layer, which may be a layer resulting from the diffusion of a metal derived from a raw material of the electrode layer 12m and a raw material of the thermoelectric conversion layer 11. The intermediate layer 12n contains an alloy containing Cu. Examples of the alloy containing Cu include alloys containing Cu and at least one selected from the group consisting of Mg, Sb, Bi, Te, and Zn. The alloy is, for example, formed by Cu and at least one selected from the group consisting of Mg, Sb, Bi, Te, and Zn that are derived from the raw material of the thermoelectric conversion layer 11 and have diffused within the first metal layer 12a or the second metal layer 12b.

The thermoelectric conversion element 10a may include an additional layer, such as an electrode layer for, for example, establishing connection to an electrical circuit and preventing oxidation of an electrode. The additional layer may be disposed on a surface that is not in contact with the first end 11a or the second end 11b in the thickness direction of the first metal layer 12a or the second metal layer 12b. The additional layer may be a single layer or multiple layers. An example of the additional layer is a layer having a structure in which a Ni layer and a Au layer are formed in this order on the first metal layer 12a or the second metal layer 12b in the thickness direction of the first metal layer 12a or the second metal layer 12b. Regarding the layers that are formed on the first metal layer 12a and the second metal layer 12b, the composition of the material, the structure of the layers, and the thickness of the layers may be the same as or different from each other. A diffusion layer may or may not be present between layers.

The thermoelectric conversion element 10a can be manufactured, for example, by performing a specific treatment on a stack of layers that includes a precursor of the thermoelectric conversion layer 11, a precursor of a metal layer, and the ceramic particles 12p. The precursor of the metal layer is formed in contact with the precursor of the thermoelectric conversion layer 11. The specific treatment includes heating the stack of layers. In this stack of layers, the ceramic particles 12p are in contact with the precursor of the thermoelectric conversion layer 11. The ceramic particles 12p are, for example, in contact with a precursor of the thermoelectric conversion layer 11 provided by cutting the thermoelectric conversion material. The ceramic particles 12p are, for example, in contact with a precursor of the thermoelectric conversion layer 11 provided by polishing the thermoelectric conversion material. The precursor of the thermoelectric conversion layer 11 becomes the thermoelectric conversion layer 11, and the precursor of the metal layer becomes the first metal layer 12a or the second metal layer 12b.

Fig. 3 is a flowchart illustrating a method for manufacturing the thermoelectric conversion element of the first embodiment. In step S11, the thermoelectric conversion material is prepared, as illustrated in Fig. 3. An example of a method for preparing the thermoelectric conversion material is described below. Methods for preparing the thermoelectric conversion material are not limited to the method described below.

A solid-state reaction is caused between raw materials that are in a mixed state. The raw materials are Mg particles and at least one type of particles selected from the group consisting of Sb particles and Bi particles. In this way, a powdered alloy containing Mg and at least one selected from the group consisting of Sb and Bi is prepared. The raw materials may be selected such that the powdered alloy contains a metal other than Sb or Bi. In the solid-state reaction, a powder of a dopant element may be mixed together as necessary. The raw materials may be particles or powders. An example of a method for causing the solid-state reaction is mechanical alloying. The alloy may be prepared by a method other than a solid-state reaction, which may be, for example, a melting method or the like.

Subsequently, the powdered alloy is sintered to form a single-crystal or polycrystalline alloy. The sintering of the powdered alloy can be accomplished, for example, by a spark plasma sintering method or a hot-press method. The resulting sintered body can be used directly as the thermoelectric conversion material. The resulting sintered body may be subjected to heat treatment, and the heat-treated sintered body may be used as the thermoelectric conversion material.

Next, in step S12, the thickness of the component including the thermoelectric conversion material is adjusted to provide a precursor of the thermoelectric conversion layer 11 having a predetermined thickness. The adjustment of the thickness of the component including the thermoelectric conversion material can be carried out, for example, by dry polishing, wet polishing, wire sawing, or blade sawing. An abrasive may be used for the adjustment of the thickness of the component including the thermoelectric conversion material. The present inventors believe that during step S12, ceramic particles 12p derived from a polishing agent or the like become embedded in the precursor of the thermoelectric conversion material layer. Examples of particles that may become embedded in the precursor of the thermoelectric conversion layer 11 include particles of a ceramic, such as alumina or SiC, that are used as an abrasive for wet polishing, and particles of diamond or the like that are used in a tool, such as a wire saw or a blade saw. In addition, a portion of a different inorganic material used in sandpaper, a polishing agent, a wire saw, or a blade saw may become embedded in the precursor of the thermoelectric conversion material layer.

Next, in step S13, the precursor of the metal layer is formed so as to be in contact with an end surface of the precursor of the thermoelectric conversion layer 11. Methods for forming the precursor of the metal layer are not limited to any particular method. Examples of methods for forming the precursor of the metal layer include electroplating, electroless plating, sputtering, and thermal spraying. In the instance where the precursor of the metal layer is formed by electroplating, a commercially available plating liquid may be used. After completion of the plating, a washing process for removing the plating liquid may be performed.

Next, in step S14, the specific treatment, which includes heating the stack of layers including the precursor of the thermoelectric conversion layer 11 and the precursor of the metal layer, is performed on the precursor of the metal layer. Consequently, the ceramic particles 12p become disposed within the interior of the first metal layer 12a or the second metal layer 12b. The specific treatment may be, for example, a treatment that includes heating the stack of layers to produce a flow of current therein such that the heating is based on conditions under which the thermoelectric conversion element 10a is expected to be used. A duration of the specific treatment may be selected in accordance with the properties required of the thermoelectric conversion element 10a. For example, the duration of the specific treatment is 500 hours. In the manner that has been described, the thermoelectric conversion element 10a can be manufactured. The specific treatment may be performed after completion of assembling for manufacturing a thermoelectric conversion module, which will be described below. The specific treatment may be performed multiple times. For example, the specific treatment may be performed both in a state in which the element is yet to be subjected to the assembling for manufacturing a thermoelectric conversion module and in a state in which the assembling for manufacturing a thermoelectric conversion module has been completed.

The specific treatment is carried out, for example, such that an absolute value of |ΔY/(Y(t)Δt)| is less than or equal to a predetermined value. ΔY is an amount of change in a specified property of the element over a period from a time t to a time t+Δt. Y(t) is a value of the specified property of the element at the time t. The specified property of the element is, for example, the electrical resistance of the element.

### (Second Embodiment)

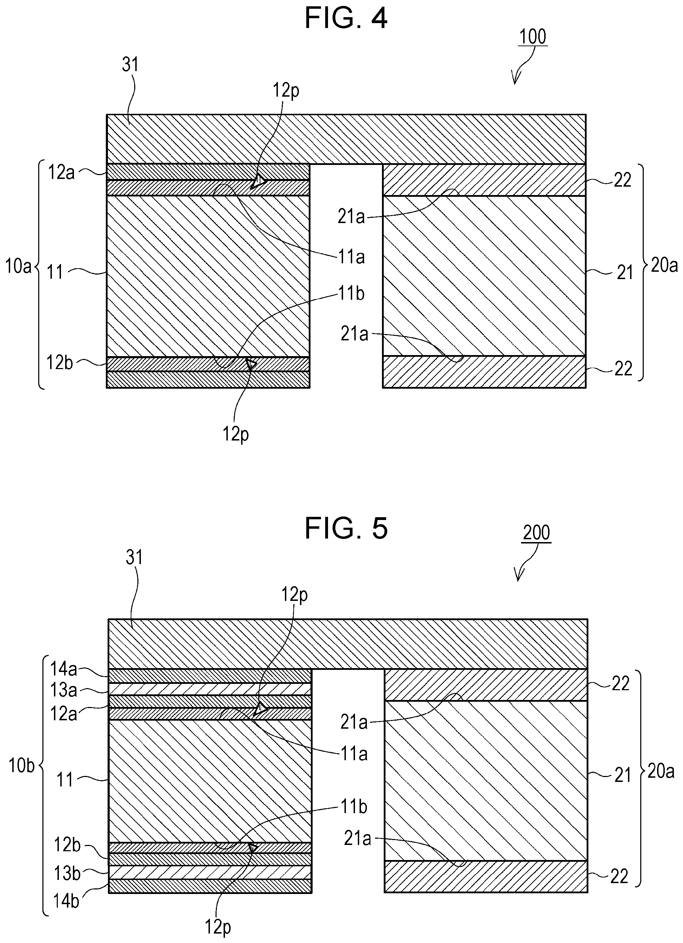

Fig. 4 is a cross-sectional view illustrating an exemplary thermoelectric conversion module of the second embodiment. As illustrated in Fig. 4, a thermoelectric conversion module 100 includes a P-type thermoelectric element 20a, an N-type thermoelectric element, which is a thermoelectric conversion element 10a, and an electrode 31. The electrode 31 electrically connects a first end portion of the P-type thermoelectric conversion element 20a to a first end portion of the N-type thermoelectric conversion element 10a. A first metal layer 12a may be directly connected to the electrode 31, or another layer may be disposed between the electrode 31 and the first metal layer 12a.

As illustrated in Fig. 4, the P-type thermoelectric element 20a includes, for example, a thermoelectric conversion layer 21 and a pair of electrode layers 22. The electrode layers 22 are each in contact with an end surface 21a of the thermoelectric conversion layer 21. The end surfaces 21a are end surfaces of the thermoelectric conversion layer 21 in a thickness direction of the electrode layers 22. The pair of electrode layers 22 are in contact with both end surfaces of the thermoelectric conversion layer 21 in the thickness direction of the electrode layers 22. The electrode layers 22 may be directly connected to the electrode 31, or another layer may be disposed between the electrode 31 and the electrode layers 22. The manner in which the P-type thermoelectric element 20a is connected to an external electrode may be the same as or different from the manner in which the N-type thermoelectric conversion element 10a is connected to an external electrode.

The thermoelectric conversion layer 21 includes a P-type thermoelectric conversion material. Examples of the P-type thermoelectric conversion material include bismuth telluride, cesium bismuth telluride, germanium telluride, bismuth antimony, Mg₃(Sb,Bi)₂, and MgAgSb. "(Sb,Bi)" means that at least one selected from the group consisting of Sb and Bi is contained. The N-type thermoelectric conversion material included in a thermoelectric conversion layer 11 and the P-type thermoelectric conversion material included in the thermoelectric conversion layer 21 may be materials of the same type of alloy system or materials of different types of alloy systems. The expression "of the same type of alloy system" means having the same alloy-forming elements. From the standpoint of decreasing a thermal stress in the thermoelectric conversion module 100, it is important that the difference in a coefficient of thermal expansion between the N-type thermoelectric conversion material included in the thermoelectric conversion layer 11 and the P-type thermoelectric conversion material included in the thermoelectric conversion layer 21 be small. For example, when the P-type thermoelectric conversion material is Mg₃(Sb,Bi)₂ or bismuth telluride, the difference in the coefficient of thermal expansion between the N-type thermoelectric conversion material and the P-type thermoelectric conversion material tends to be small.

When the P-type thermoelectric conversion material is bismuth telluride, the electrode layers 22 are, for example, Ni-plated layers, Ni-thermal-sprayed layers, Ni-sputtered layers, Mo-thermal-sprayed layers, or the like. When the P-type thermoelectric conversion material is bismuth telluride and has a composition represented by Bi₂Teₓ, x in this composition satisfies, for example, the condition of 2 < x < 4. The composition of the bismuth telluride may be Bi₂Te₃. The bismuth telluride may contain at least one selected from the group consisting of antimony and selenium. The bismuth telluride containing antimony has a composition of, for example, (Bi_{1-y}Sb_{y})₂Teₓ. When the P-type thermoelectric conversion material has the composition of (Bi_{1-y}Sb_{y})₂Teₓ, the condition of 0 < y **< 1,** for example, is satisfied, and desirably, the condition of 0.6 < y < 0.9 is satisfied.

Fig. 5 is a cross-sectional view illustrating another exemplary thermoelectric conversion module. As illustrated in Fig. 5, a thermoelectric conversion module 200 has the same configuration as that of the thermoelectric conversion module 100, except that a thermoelectric conversion element 10b is included as the N-type thermoelectric conversion element instead of the thermoelectric conversion element 10a. The thermoelectric conversion element 10b has the same configuration as that of the thermoelectric conversion element 10a, except for portions that are particularly described. Constituent elements of the thermoelectric conversion element 10b that are the same as or correspond to the constituent elements of the thermoelectric conversion element 10a are assigned the same reference numerals, and details thereof will not be described. The descriptions of the thermoelectric conversion element 10a apply to the thermoelectric conversion element 10b as long as there is no technical inconsistency.

As illustrated in Fig. 5, the thermoelectric conversion element 10b includes a first metal layer 12a, an electrode layer 13a, an electrode layer 14a, a second metal layer 12b, an electrode layer 13b, and an electrode layer 14b. The first metal layer 12a, the electrode layer 13a, and the electrode layer 14a are disposed in this order in the thermoelectric conversion element 10b, starting from a first end 11a of the thermoelectric conversion layer 11, in a thickness direction of the first metal layer 12a. The thermoelectric conversion layer 11 is electrically connected to an electrode 31 via the first metal layer 12a, the electrode layer 13a, and the electrode layer 14a. The second metal layer 12b, the electrode layer 13b, and the electrode layer 14b are disposed in this order in the thermoelectric conversion element 10b, starting from a second end 11b of the thermoelectric conversion layer 11, in a thickness direction of the second metal layer 12b.

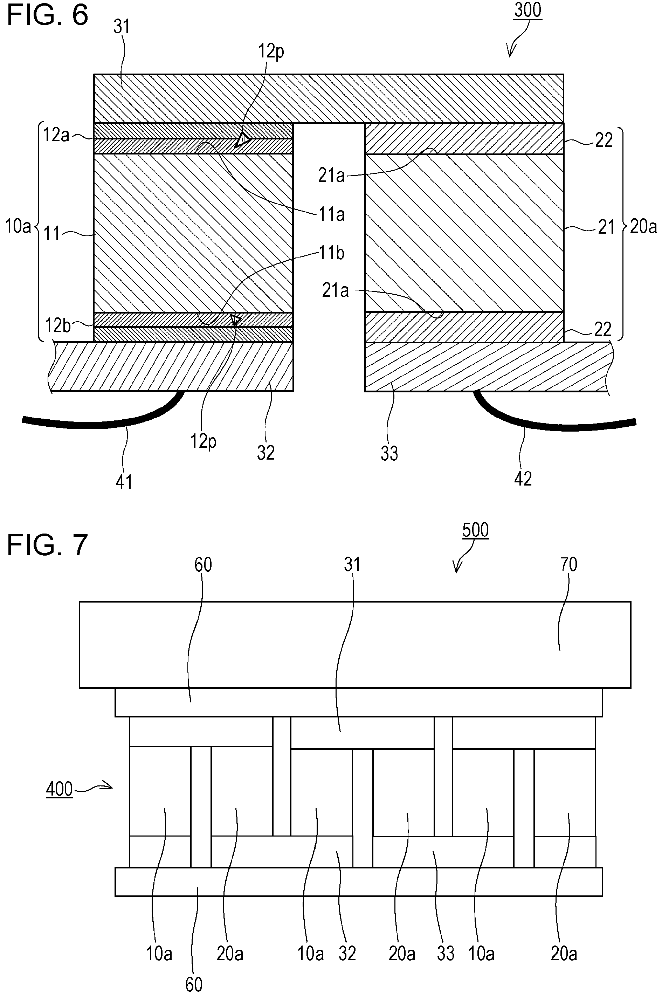

Fig. 6 is a cross-sectional view illustrating yet another exemplary thermoelectric conversion module. A thermoelectric conversion module 300, illustrated in Fig. 6, has the same configuration as that of the thermoelectric conversion module 100, except for portions that are particularly described. As illustrated in Fig. 6, the thermoelectric conversion module 300 further includes an electrode 32 and an electrode 33. A second end portion of an N-type thermoelectric conversion element 10a is electrically connected to the electrode 32 via a second metal layer 12b. A second end portion of a P-type thermoelectric conversion element 20a is electrically connected to the electrode 33 via an electrode layer 22. The thermoelectric conversion module 300 further includes a first wiring 41 and a second wiring 42. The first wiring 41 is connected to the electrode 32. The second wiring 42 is connected to the electrode 33. The first wiring 41 and the second wiring 42 serve to, for example, apply a voltage to the N-type thermoelectric conversion element 10a and the P-type thermoelectric conversion element 20a. The first wiring 41 and the second wiring 42 may serve to supply electricity generated in the thermoelectric conversion module 300 to an outside of the thermoelectric conversion module 300.

### (Third Embodiment)

Fig. 7 is a side view illustrating a thermoelectric conversion system of the third embodiment. As illustrated in Fig. 7, a thermoelectric conversion system 500 includes a thermoelectric conversion module 400 and a heat source 70. The thermoelectric conversion module 400 has the same configuration as that of the thermoelectric conversion module 100, except for portions that are particularly described. The thermoelectric conversion module 400 includes an electrode 31, an electrode 32, and an electrode 33. The heat source 70 is disposed adjacent to the electrode 31. The electrode 32 and the electrode 33 each electrically connect a second end portion of a P-type thermoelectric conversion element 20a to a second end portion of an N-type thermoelectric conversion element 10a.

The thermoelectric conversion system 500 further includes, for example, a pair of substrates 60. One of the pair of substrates 60 is disposed in contact with the electrode 31, and the other of the pair of substrates 60 is disposed in contact with the electrode 32 and the electrode 33. This configuration makes it unlikely that temperature variations occur in a direction parallel to a major surface of the substrates 60 in the thermoelectric conversion system 500. The substrates 60 are made of a material that is not limited to any particular material. For example, the substrates 60 contain alumina or aluminum nitride.

With the thermoelectric conversion system 500, it is possible to provide a method for generating electrical power that includes generating electrical power by applying a temperature difference to the thermoelectric conversion module 400 by using heat from the heat source 70.

The thermoelectric conversion elements of the above-described embodiments can be used in a variety of applications, including, for example, applications of thermoelectric conversion elements of the related art. The thermoelectric conversion modules 100, 200, 300, and 400 can be manufactured by assembling an N-type thermoelectric conversion element 10a or 10b with a P-type thermoelectric conversion element 20a by a method known in the art.

### (Supplementary Notes)

the following technologies are disclosed on the basis of the above description.

### (Technology 1)

A thermoelectric conversion element comprising:
a first metal layer;
a second metal layer; and
a thermoelectric conversion layer that is disposed between the first metal layer and the second metal layer in a thickness direction of the first metal layer and comprises a thermoelectric conversion material comprising Mg, wherein
the first metal layer comprises ceramic particles, and
the ceramic particles are disposed within an interior of the first metal layer.

### (Technology 2)

The thermoelectric conversion element according to Technology 1, wherein the thermoelectric conversion material further comprises at least one selected from the group consisting of Sb and Bi.

### (Technology 3)

The thermoelectric conversion element according to Technology 1 or 2, wherein the first metal layer further comprises
an electrode layer comprising Cu, and
**an intermediate** layer that is disposed between the electrode layer and the thermoelectric conversion layer in the thickness direction of the first metal layer and comprises Mg and Cu.

### (Technology 4)

The thermoelectric conversion element according to Technology 3, wherein the ceramic particles are disposed in at least one selected from the group consisting of (a), (b), and (c), which will be listed below:
(a) an interior of the electrode layer,
(b) an interior of the intermediate layer, and
(c) a boundary region between the electrode layer and the intermediate layer.

### (Technology 5)

The thermoelectric conversion element according to any one of Technologies 1 to 4, wherein the ceramic particles comprise alumina.

### (Technology 6)

The thermoelectric conversion element according to any one of Technologies 1 to 5, wherein the ceramic particles comprise at least one selected from the group consisting of SiC and SiO₂.

### (Technology 7)

The thermoelectric conversion element according to any one of Technologies 1 to 6, wherein in an instance where a cross section of the first metal layer in the thickness direction thereof is observed by scanning electron microscopy-energy dispersive X-ray spectroscopy, the ceramic particles in the cross section satisfy a first condition expressed as 0.5 µm ≤ d, where d is a maximum dimension of the ceramic particles.

### (Technology 8)

The thermoelectric conversion element according to Technology 7, wherein the ceramic particles in the cross section satisfy a second condition expressed as d ≤ 10 µm.

### (Technology 9)

The thermoelectric conversion element according to Technology 3, wherein
the ceramic particles are disposed in the intermediate layer, and
the first metal layer satisfies a third condition expressed as 0.1 ≤ d/A ≤ 10, where d is a maximum dimension of the ceramic particles in a cross section of the first metal layer in the thickness direction thereof as observed by scanning electron microscopy-energy dispersive X-ray spectroscopy, and A is a thickness of the intermediate layer.

### (Technology 10)

The thermoelectric conversion element according to any one of Technologies 1 to 9, wherein the thermoelectric conversion material has a La₂O₃-type crystal structure.

### (Technology 11)

The thermoelectric conversion element according to any one of claims 1 to 10, wherein the thermoelectric conversion material further comprises Te.

### (Technology 12)

The thermoelectric conversion element according to any one of Technologies 1 to 11, wherein the thermoelectric conversion material has a composition represented by Mg₃₊ₘRₐT_{b}Sb_{2-e-c}Bi_{c}Zₑ, where
the element R is at least one element selected from the group consisting of Ca, Sr, Ba, and Yb,
the element T is at least one element selected from the group consisting of Mn and Zn,
the element Z is at least one element selected from the group consisting of Te, Se, Sc, Y, and La,
a value of m satisfies -0.39 ≤ m ≤ 0.42,
a value of a satisfies 0 ≤ a ≤ 0.12,
a value of b satisfies 0 ≤ b ≤ 0.48,
a value of c satisfies 0 ≤ c ≤ 1.6, and
a value of e satisfies 0.001 ≤ e ≤ 0.06.

### (Technology 13)

A thermoelectric conversion module comprising:
a P-type thermoelectric conversion element;
an N-type thermoelectric conversion element; and
an electrode electrically connecting a first end portion of the P-type thermoelectric conversion element to a first end portion of the N-type thermoelectric conversion element, wherein
the N-type thermoelectric conversion element is the thermoelectric conversion element according to any one of Technologies 1 to 12.

### (Technology 14)

A thermoelectric conversion system comprising:
the thermoelectric conversion module according to Technology 13; and
a heat source disposed adjacent to the electrode.

### (Technology 15)

A method for generating electrical power, the method comprising generating electrical power by creating a temperature difference in the thermoelectric conversion module according to Technology 13 by using heat from a heat source.

### (Technology 16)

A method for manufacturing a thermoelectric conversion element, the method comprising performing a specific treatment on a stack of layers to provide the thermoelectric conversion element, the stack of layers comprising a precursor of a thermoelectric conversion layer, a precursor of a metal layer, and ceramic particles, the precursor of the metal layer being formed in contact with the precursor of the thermoelectric conversion layer, the specific treatment comprising heating the stack of layers, wherein
the ceramic particles are in contact with the precursor of the thermoelectric conversion layer in the stack of layers,
the thermoelectric conversion layer comprises a thermoelectric conversion material comprising Mg, and
the ceramic particles are disposed within an interior of the metal layer in the thermoelectric conversion element.

### (Technology 17)

The method for manufacturing the thermoelectric conversion element according to Technology 16, further comprising providing the precursor of the thermoelectric conversion layer by cutting the thermoelectric conversion material.

### (Technology 18)

The method for manufacturing the thermoelectric conversion element according to Technology 16 or 17, further comprising providing the precursor of the thermoelectric conversion layer by polishing the thermoelectric conversion material.

### EXAMPLES

The present disclosure will now be described in detail with reference to examples. Note that the thermoelectric conversion elements of the present disclosure are not limited to the examples described below.

### (Working example 1)

Approximately 2.9 g of a powder of an alloy produced by a solid-state reaction and had a composition of Mg_{3.2}Sb_{1.5}Bi_{0.49}Te_{0.01} was weighed in a glove box. The alloy was. An argon atmosphere was maintained in the glove box until a thermoelectric conversion material was obtained. Next, the weighed powder was compacted into a sintering space in a carbon die and compressed with a carbon punch. The die had an inside diameter of 10 mm. Next, the die was placed in a chamber of a spark plasma sintering apparatus. An argon atmosphere was maintained in the chamber. Next, a current was applied to the die with the sintering apparatus while a pressure of 50 MPa was applied to the compact in the die. As a result of the application of the current, the temperature of the die reached 840°C, which was a sintering temperature, and subsequently, the temperature was maintained for 10 minutes. Subsequently, the heating of the die was discontinued by decreasing the current flowing through the die. After a decrease in the die temperature to room temperature was observed, the sintered body was ejected from the die to provide a thermoelectric conversion material of the working example 1. A surface of the ejected thermoelectric conversion material, which was the sintered body, was polished and subsequently washed with acetone, the surface being a surface that was in contact with the interior surface of the die. The sintered body of the working example 1 had a thickness of approximately 6.5 mm.

The sintered body prepared as described above was cut with a wire saw along a plane perpendicular to the direction of pressing, to form two sintered bodies each having a thickness of approximately 2.9 mm. For the cutting of the sintered body with a wire saw, alumina particles were used as an abrasive. The alumina particles had a particle size of #220. After the sintered body was cut with the wire saw, the sintered bodies were washed with acetone.

For the sintered bodies prepared as described above and having a thickness of approximately 2.9 mm, Cu electroplating was performed on both of their end surfaces to form plated layers. After completion of the plating, the sintered bodies were washed.

The sintered bodies on which the plated layers were formed were processed into a rectangular parallelepiped shape with a wire saw. Consequently, the sintered bodies had a square shape contour with a side length of approximately 3 mm in a plane parallel to the plated layers. In addition, a distance between the plated layers was approximately 2.9 mm.

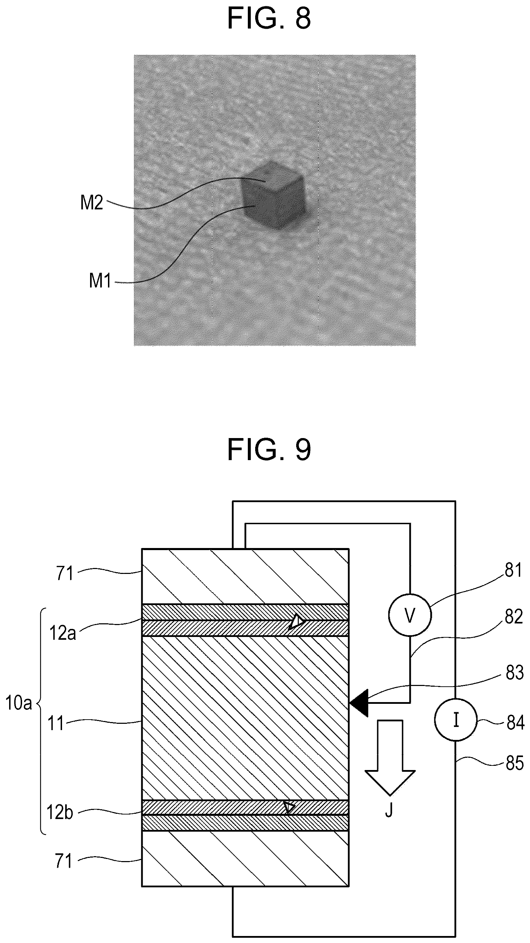

Next, the pair of plated layers formed on both end surfaces of the sintered bodies were connected to external electrodes, and the specific treatment was performed. The specific treatment was as follows. A flow of current was produced between the pair of plated layers in a state in which a heater block that had been heated to 100°C was in contact with one of the plated layers. In addition, a flow of current was produced between the pair of plated layers in a state in which a heater block that had been heated to 100°C was in contact with the other of the plated layers. In this manner, a thermoelectric conversion element of the working example 1 was prepared. The thermoelectric conversion element of the working example 1 included a thermoelectric conversion layer derived from a sintered body and included metal layers derived from plated layers. The specific treatment was performed until |ΔR/(R(t)Δt)| reached less than or equal to 1%/100 hours. ΔR is an amount of change in the electrical resistance of the element over a period from a time t to a time t+Δt. R(t) is the electrical resistance of the element at the time t. Fig. 8 is a photograph showing the thermoelectric conversion element of the working example 1. In Fig. 8, M1 represents a thermoelectric conversion layer, and M2 represents a metal layer.

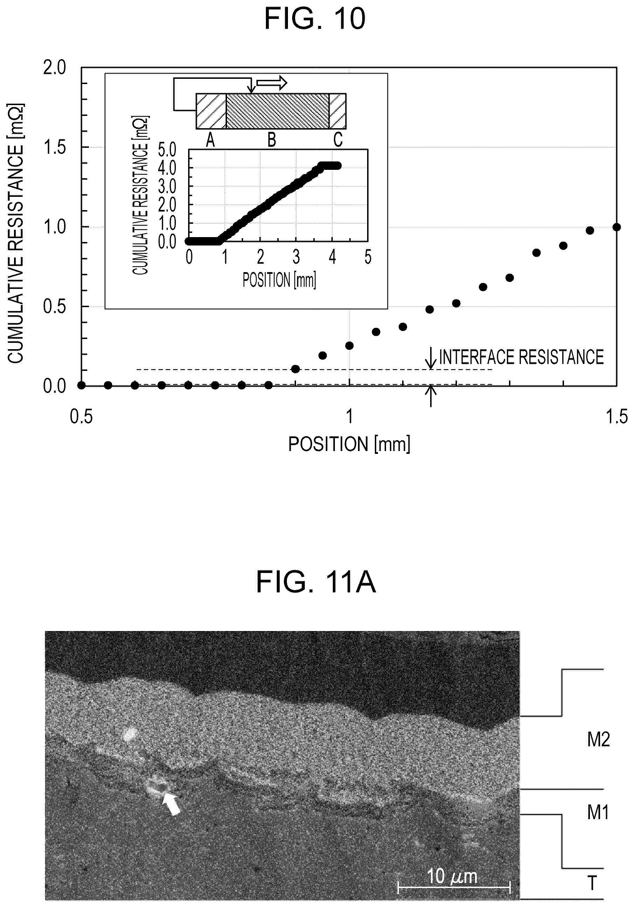

The interface resistivity at the interface between the thermoelectric conversion layer and the metal layer in the thermoelectric conversion element of the working example 1 was determined as follows. Fig. 9 is a schematic diagram illustrating a manner of measuring the electrical resistance of a thermoelectric conversion element. As illustrated in Fig. 9, a pair of external electrodes 71 are attached to a thermoelectric conversion element 10a. An ammeter 84 is electrically connected to both of the pair of electrodes 71 with a lead 85. A voltmeter 81 is connected to one of the external electrodes 71 with a lead 82, and a probe 83 is connected to an end portion of the lead 82, the end portion being located opposite to the one of the external electrodes 71. The electrical resistance was measured with a four-terminal method, while the probe 83 was moved 50 µm each time from the one of the external electrodes 71 to the other of the external electrodes 71 in a direction indicated by an arrow J. The measurement of the electrical resistance was carried out with a source meter (model number: 2400) manufactured by Keithley Instruments, Inc. Fig. 10 is a graph showing exemplary results of measuring the electrical resistance of the thermoelectric conversion element of the working example 1. In Fig. 10, "A" is a portion corresponding to the first metal layer 12a and the one of the external electrodes 71. "B" is a portion corresponding to the thermoelectric material layer 11. "C" is a portion corresponding to the second metal layer 12b and the other of the external electrodes 71. The amount of change in the electrical resistance at the boundary between A and B corresponds to the interface resistance at the interface between the thermoelectric conversion layer and the first metal layer. The interface resistivity at the interface between the thermoelectric conversion layer and the metal layer in the thermoelectric conversion element of the working example 1 was determined from the interface resistance mentioned above and an area of a cross section of the thermoelectric conversion element of the working example 1, the cross section being parallel to the metal layer. The result was that the interface resistivity was 1.92 mΩmm².

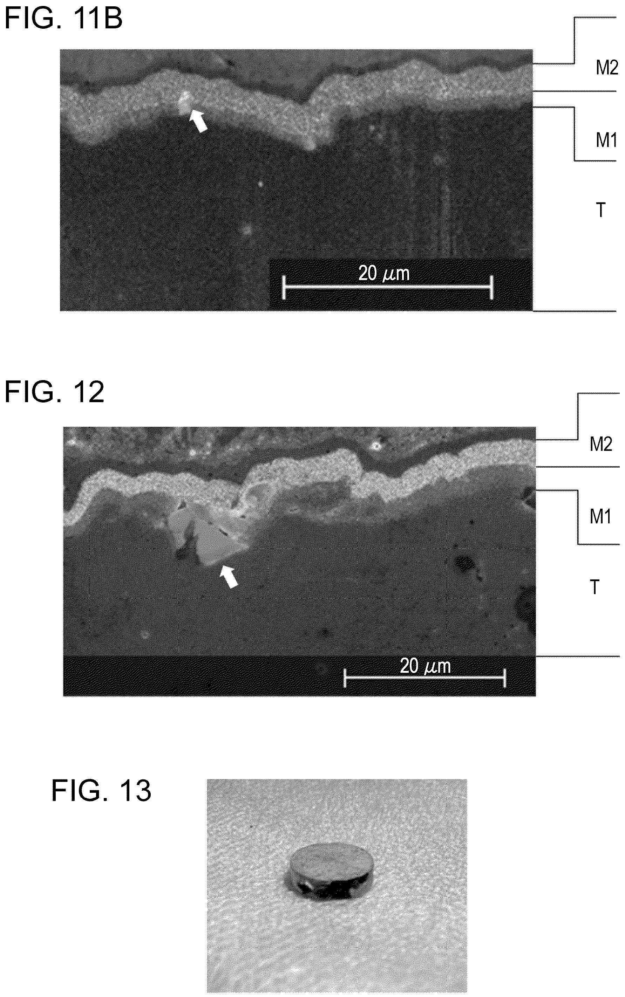

Next, a smooth cross section including the interface between the thermoelectric conversion layer and the metal layer was formed by performing argon ion milling in a direction perpendicular to the interface between the thermoelectric conversion layer and the metal layer of the thermoelectric conversion element of the working example 1. Composition analysis by SEM-EDX was performed on the smooth cross section with a field emission scanning electron microscope (FE-SEM) SU8220, manufactured by Hitachi High-Tech Corporation, and a FlatQUAD EDX detector, manufactured by Bruker AXS Inc. The results are shown in Figs. 11A and 11B. Figs. 11A and 11B are micrographs of the cross section of the thermoelectric conversion element of the working example 1, the micrographs being obtained by SEM-EDX. In Figs. 11A and 11B, the region corresponding to "T" is the thermoelectric conversion layer, the region corresponding to "M1" is the intermediate layer, and the region corresponding to "M2" is the electrode layer. In other words, the metal layer included an intermediate layer M1 and an electrode layer M2. The intermediate layer M1 contained Cu and Mg and thus was believed to be a diffusion layer. In the field of view shown in Fig. 11A, alumina particles were present within the interior of the intermediate layer M1, as indicated by the white arrow. In the field of view shown in Fig. 11B, alumina particles were present in a region extending from the intermediate layer M1 to the electrode layer M2, as indicated by the white arrow. The alumina particles had a maximum dimension of, for example, 2.5 µm, as determined from an elemental mapping image of a cross section of the thermoelectric conversion element obtained by SEM-EDX. Furthermore, a full width at half maximum of a peak corresponding to the alumina particles was 1.0 µm as determined from an SEM-EDX line scanning composition analysis. The same measurement was performed on other locations, and the present inventors found that the alumina particles had a maximum dimension of, for example, 0.5 µm to 10 µm, as determined from an elemental mapping image of cross sections of the thermoelectric conversion element obtained by SEM-EDX. The full width at half maximum of peaks corresponding to the alumina particles was 0.1 µm to 5 µm as determined from the SEM-EDX line scanning composition analysis. The intermediate layer M1 had a thickness of, for example, 2 µm and thicknesses of 1 µm to 5 µm in other locations. In other words, the size of the alumina particles was 0.1 to 10 times as large as the thickness of the intermediate layer.

### (Working examples 2 to 12)

Thermoelectric conversion elements of the working examples 2 to 12 were prepared in the same manner as in the working example 1, except that powders of alloys each having the composition shown in Table 1 were used. The thermoelectric conversion elements of the working examples 2 to 12 were evaluated in the same manner as the thermoelectric conversion element of the working example 1. The interface resistivity at the interface between the thermoelectric conversion layer and the metal layer in the thermoelectric conversion element of each of the working examples 2 to 12 is shown in Table 1. From the results of SEM-EDX performed on a cross section of the thermoelectric conversion element, it was found that alumina particles were present within the interior of the metal layer (first metal layer).

### (Working example 13)

A thermoelectric conversion element of the working example 13 was prepared in the same manner as in the working example 1, except that the abrasive used for the cutting of the sintered body was SiC. The thermoelectric conversion element of the working example 13 was evaluated in the same manner as the thermoelectric conversion element of the working example 1. The interface resistivity at the interface between the thermoelectric conversion layer and the metal layer in the thermoelectric conversion element of the working example 13 is shown in Table 1. From the results of SEM-EDX performed on a cross section of the thermoelectric conversion element, the present inventors found that SiC particles were present within the interior of the metal layer (first metal layer).

### (Working example 14)

A thermoelectric conversion element of the working example 14 was prepared in the same manner as in the working example 1, except that the abrasive used for the cutting of the sintered body was SiO₂. The thermoelectric conversion element of the working example 14 was evaluated in the same manner as the thermoelectric conversion element of the working example 1. The interface resistivity at the interface between the thermoelectric conversion layer and the metal layer in the thermoelectric conversion element of the working example 14 is shown in Table 1. From the results of SEM-EDX performed on a cross section of the thermoelectric conversion element, the present inventors found that SiO₂ particles were present within the interior of the metal layer (first metal layer).

### (Comparative example 1)

A thermoelectric conversion element of the comparative example 1 was prepared in the same manner as in the working example 1, except that the specific treatment was not performed.

The thermoelectric conversion element of the comparative example 1 was evaluated in the same manner as the thermoelectric conversion element of the working example 1. The interface resistivity at the interface between the thermoelectric conversion layer and the metal layer in the thermoelectric conversion element of the comparative example 1 is shown in Table 1. Fig. 12 is a micrograph of a cross section of the thermoelectric conversion element of the comparative example 1, the micrograph having been obtained by SEM-EDX. As indicated by a white arrow in Fig. 12, the present inventors found that alumina particles were in direct contact with the thermoelectric conversion layer at the interface between the thermoelectric conversion layer and the metal layer.

### (Comparative example 2)

A thermoelectric conversion element of the comparative example 2 was prepared in the same manner as in Comparative the working example 1, except that the powder of an alloy used was a powder of an alloy having a composition of Mg_{3.2}Sb_{1.0}Bi_{0.99}Te_{0.01}. The thermoelectric conversion element of the comparative example 2 was evaluated in the same manner as the thermoelectric conversion element of the working example 1. The interface resistivity at the interface between the thermoelectric conversion layer and the metal layer in the thermoelectric conversion element of the comparative example 2 is shown in Table 1. From the results of SEM-EDX performed on a cross section of the thermoelectric conversion element, the present inventors found that alumina particles were in direct contact with the thermoelectric conversion layer at the interface between the thermoelectric conversion layer and the metal layer.

### (Comparative example 3)

The cutting of the sintered body was performed in the same manner as in the comparative example 1, except that for the cutting of the sintered body, alumina particles having a particle size of #36 were used as the abrasive. After completion of the cutting, Cu electroplating was performed on both end surfaces of the resulting sintered body. However, the plated layer peeled off, and thus, it was not possible to prepare a thermoelectric conversion element. Fig. 13 is a photograph showing the peeling of the plated layer of the comparative example 3.

As shown in Table 1, the interface resistivities at the interface between the thermoelectric conversion layer and the metal layer in the thermoelectric conversion elements of the working examples were lower than the interface resistivities at the interface between the thermoelectric conversion layer and the metal layer in the thermoelectric conversion elements of the comparative examples 1 and 2. It was suggested that in the instance where the particles derived from an abrasive are present within the interior of the metal layer, the interface resistivity at the interface between the thermoelectric conversion layer and the metal layer is decreased, which is advantageous in terms of decreasing the electrical resistance of thermoelectric conversion elements.

**[Table 1]**

| | Composition of Thermoelectric Conversion Material | Interface Resistivity [mΩmm²] |
|---|---|---|
| Working example 1 | Mg_{3.2}Sb_{1.5}Bi_{0.49}Te_{0.01} | 1.92 |
| Working Example 2 | Mg_{3.1}Sb_{1.5}Bi_{0.49}Te_{0.01} | 1.50 |
| Working Example 3 | Mg_{3.05}Sb_{1.5}Bi_{0.49}Te_{0.01} | 2.07 |
| Working Example 4 | Mg_{3.2}Sb_{1.0}Bi_{0.99}Te_{0.01} | 2.40 |
| Working Example 5 | Mg_{3.1}Sb_{1.0}Bi_{0.99}Te_{0.01} | 1.92 |
| Working Example 6 | Mg_{3.05}Sb_{1.0}Bi_{0.99}Te_{0.01} | 2.28 |
| Working Example 7 | Mg_{3.2}Sb_{1.2}Bi_{0.49}Te_{0.01}Mn_{0.01} | 2.33 |
| Working Example 8 | Mg_{3.2}Sb_{1.2}Bi_{0.49}Te_{0.01}Zn_{0.01} | 2.07 |
| Working Example 9 | Mg_{3.2}Sb_{1.0}Bi_{0.99}Te_{0.01}Mn_{0.01} | 2.56 |
| Working example 10 | Mg_{3.2}Sb_{1.0}Bi_{0.99}Te_{0.01}Zn_{0.01} | 2.21 |
| Working example 11 | Mg_{3.2}Yb_{0.06}Sb_{1.0}Bi_{0.99}Te_{0.01} | 2.17 |
| Working example 12 | Mg_{3.2}Sb_{0.5}Bi_{1.49}Te_{0.01} | 2.86 |
| Working example 13 | Mg_{3.2}Sb_{1.5}Bi_{0.49}Te_{0.01} | 3.82 |
| Working example 14 | Mg_{3.2}Sb_{1.5}Bi_{0.49}Te_{0.01} | 3.65 |
| Comparative example 1 | Mg_{3.2}Sb_{1.5}Bi_{0.49}Te_{0.01} | 7.20 |
| Comparative example 2 | Mg_{3.2}Sb_{1.0}Bi_{0.99}Te_{0.01} | 9.89 |
| Comparative example 3 | Mg_{3.2}Sb_{1.5}Bi_{0.49}Te_{0.01} | - |

The thermoelectric conversion elements of the present disclosure can be used in a variety of applications, including applications of thermoelectric conversion elements of the related art.

### REFERENCE SIGNS LIST

10a, 10b thermoelectric conversion element
11 thermoelectric conversion layer
12a first metal layer
12b second metal layer
12m electrode layer
12n intermediate layer
12p ceramic particles
20a P-type thermoelectric conversion element
31 electrode
70 heat source
100, 200, 300, 400 thermoelectric conversion module
500 thermoelectric conversion system

## Claims

1. A thermoelectric conversion element comprising:
a first metal layer;
a second metal layer; and
a thermoelectric conversion layer that is disposed between the first metal layer and the second metal layer in a thickness direction of the first metal layer and comprises a thermoelectric conversion material comprising Mg, wherein
the first metal layer comprises ceramic particles, and
the ceramic particles are disposed within an interior of the first metal layer.

2. The thermoelectric conversion element according to claim 1, wherein the thermoelectric conversion material further comprises at least one selected from the group consisting of Sb and Bi.

3. The thermoelectric conversion element according to claim 1, wherein the first metal layer further comprises
an electrode layer comprising Cu, and
an intermediate layer that is disposed between the electrode layer and the thermoelectric conversion layer in the thickness direction of the first metal layer and comprises Mg and Cu.

4. The thermoelectric conversion element according to claim 3, wherein the ceramic particles are disposed in at least one selected from the group consisting of the following (a), (b), and (c):
(a) an interior of the electrode layer,
(b) an interior of the intermediate layer, and
(c) a boundary region between the electrode layer and the intermediate layer.

5. The thermoelectric conversion element according to claim 1, wherein the ceramic particles comprise alumina.

6. The thermoelectric conversion element according to claim 1, wherein the ceramic particles comprise at least one selected from the group consisting of SiC and SiO₂.

7. The thermoelectric conversion element according to claim 1, wherein in an instance where a cross section of the first metal layer in the thickness direction thereof is observed by scanning electron microscopy-energy dispersive X-ray spectroscopy, the ceramic particles in the cross section satisfy a first condition expressed as 0.5 µm ≤ d, where d is a maximum dimension of the ceramic particles.

8. The thermoelectric conversion element according to claim 7, wherein the ceramic particles in the cross section satisfy a second condition expressed as d ≤ 10 µm.

9. The thermoelectric conversion element according to claim 3, wherein
the ceramic particles are disposed in the intermediate layer, and
the first metal layer satisfies a third condition expressed as 0.1 ≤ d/A ≤ 10, where d is a maximum dimension of the ceramic particles in a cross section of the first metal layer in the thickness direction thereof as observed by scanning electron microscopy-energy dispersive X-ray spectroscopy, and A is a thickness of the intermediate layer.

10. The thermoelectric conversion element according to claim 1, wherein the thermoelectric conversion material has a La₂O₃ crystal structure.

11. The thermoelectric conversion element according to claim 1, wherein the thermoelectric conversion material further comprises Te.

12. The thermoelectric conversion element according to claim 1, wherein the thermoelectric conversion material has a composition represented by Mg₃₊ₘRₐT_{b}Sb_{2-e-c}Bi_{c}Zₑ, where
the element R is at least one element selected from the group consisting of Ca, Sr, Ba, and Yb,
the element T is at least one element selected from the group consisting of Mn and Zn,
the element Z is at least one element selected from the group consisting of Te, Se, Sc, Y, and La,
a value of m satisfies -0.39 ≤ m ≤ 0.42,
a value of a satisfies 0 ≤ a ≤ 0.12,
a value of b satisfies 0 ≤ b ≤ 0.48,
a value of c satisfies 0 ≤ c ≤ 1.6, and
a value of e satisfies 0.001 ≤ e ≤ 0.06.

13. A thermoelectric conversion module comprising:
a P-type thermoelectric conversion element;
an N-type thermoelectric conversion element; and
an electrode electrically connecting a first end portion of the P-type thermoelectric conversion element to a first end portion of the N-type thermoelectric conversion element, wherein
the N-type thermoelectric conversion element is the thermoelectric conversion element according to claim 1.

14. A thermoelectric conversion system comprising:
the thermoelectric conversion module according to claim 13; and
a heat source disposed adjacent to the electrode.

15. A method for generating electrical power, the method comprising generating electrical power by applying a temperature difference to the thermoelectric conversion module according to claim 13 by using heat from a heat source.

16. A method for manufacturing a thermoelectric conversion element, the method comprising performing a specific treatment on a stack of layers to provide the thermoelectric conversion element, the stack of layers comprising a precursor of a thermoelectric conversion layer, a precursor of a metal layer, and ceramic particles, the precursor of the metal layer being formed in contact with the precursor of the thermoelectric conversion layer, the specific treatment comprising heating the stack of layers, wherein
the ceramic particles are in contact with the precursor of the thermoelectric conversion layer in the stack of layers,
the thermoelectric conversion layer comprises a thermoelectric conversion material comprising Mg, and
the ceramic particles are disposed within an interior of the metal layer in the thermoelectric conversion element.

17. The method for manufacturing the thermoelectric conversion element according to claim 16, further comprising providing the precursor of the thermoelectric conversion layer by cutting the thermoelectric conversion material.

18. The method for manufacturing the thermoelectric conversion element according to claim 16, further comprising providing the precursor of the thermoelectric conversion layer by polishing the thermoelectric conversion material.
